(19) Europäisches Patentamt
European Patent Office
Office européen des brevets

(11) Numéro de publication: **0 079 845**
**B1**

(12) # FASCICULE DE BREVET EUROPEEN

(45) Date de publication du fascicule du brevet: **19.03.86**

(51) Int. Cl.⁴: **H 01 L 27/01**, H 01 B 1/16

(21) Numéro de dépôt: **82420152.9**

(22) Date de dépôt: **09.11.82**

(54) **Procédé de fabrication de circuits électroniques de type hybride à couches épaisses, des moyens destinés à la mise en oeuvre de ce procédé et les circuits obtenus selon ce procédé.**

(30) Priorité: **17.11.81 FR 8121642**

(43) Date de publication de la demande:
**25.05.83 Bulletin 83/21**

(45) Mention de la délivrance du brevet:
**19.03.86 Bulletin 86/12**

(84) Etats contractants désignés:
**BE DE GB IT NL SE**

(56) Documents cités:
**FR - A - 2 184 391**
**GB - A - 1 374 763**
**US - A - 2 993 815**

**CHEMICAL ABSTRACTS, vol. 76, 1972, page 317, col. 1, no. 63968m, Columbus Ohio (USA); A. PROKOPCIKAS et al.:** ***"Reduction of copper subgroup metal compounds by sodium borohydride in alkaline solutions"***

(73) Titulaire: **RHONE-POULENC SPECIALITES CHIMIQUES, "Les Miroirs" 18, Avenue d'Alsace, F-92400 Courbevoie (FR)**

(72) Inventeur: **Cassat, Robert, Chemin de Crapon, F-69360 Ternay (FR)**

(74) Mandataire: **Varnière-Grange, Monique et al, RHONE-POULENC RECHERCHES Service Brevets Chimie et Polymères Centre de Recherches de Saint-Fons 85, avenue des Frères Perret B.P. 62, F-69192 St-Fons Cédex (FR)**

EP 0 079 845 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1986

**Description**

La présente invention se rapporte à un procédé de fabrication de circuits électroniques de type hybride à couches épaisses. La présente invention concerne également des moyens destinés à la mise en oeuvre de ce procédé et les circuits obtenus selon ce procédé.

La microélectronique hybride s'est developpée pour répondre à un double souci: résoudre les problèmes d'encombrement et améliorer la fiabilité des circuits. A la différence d'un circuit monolithique qui est obtenu à partir d'un substrat semi-conducteur ou tous les composants (actifs et passifs) sont réalises simultanément au cours d'un unique processus, un circuit hybride est réalisé sur un substrat isolant et ne comporte que des éléments passifs; les éléments actifs s'il y en a, semi-conducteurs ou circuit intégrés sont ensuite rapportés par soudure. Les circuits hybrides sont classes e circuits à couches minces et circuits à couches épaisses. Cette classification se réfère à l'epaisseur des couches déposées: de 0,02 à 10 $\mu$ m pour les couches minces et de10 à 50$\mu$ m pour les couches epaisses.

Pour les couches minces, le depôt des couches est réalisé en appliquant généralement les techniques d'evaporation sous vide ou de pulvérisation cathodique. Pour les hybrides à couches épaisses, la technologie utilisée consiste generalement à imprimer directement les circuits voulus sur le substrat isolant au moyen des procédés classiques de sérigraphie.

La sérigraphie consiste à forcer l'encre que l'on veut déposer sur le substrat à travers les fines mailles d'un écran dont certaines sont obturées par une laque spéciale, les mailles libres représentant très exactement le dessin tramé du circuit à reproduire.

Tout circuit hybride doit être élaboré sur un substrat. Du bon choix de celui-ci dépendra la qualité finale du circuit. Le substrat joue en général un triple rôle: celui de support mécanique, non seulement pour le circuit déposé mais aussi pour les composants actifs qu'il recerva; celui d'isolant électrique, sa résistivité devant donc être la plus élevée possible et son coefficient de perte le plus bas possible; celui de dissipateur thermique, ce qui exige donc une exellente conductivité thermique et une chaleur spécifique élevée. Parmi les substrats qui conviennent, on peut citer: des matières inorganiques comme par exemple les céramiques telles que l'oxyde de beryllium, l'alumine et le verre Pyrex; des matières organiques comme par exemple des résines renforcées faites à partir de matières polymériques thermodurcissables.

Une fois qu'il a reçu une impression conductrice, isolante ou résistante sous forme d'encre à rhéologie définie, le substrat est cuit au four afin que le dépôt se solidarise parfaitement avec le substrat. Enfin les fils de sortie sont fixés et après montage éventuel des composants actifs, le module terminé peut être enrobé par encapsalution dans un verre ou une résine polymérique afin de le soustraire à l'action de l'humidité et de faciliter sa manutention.

Pratiquement tous les circuits à couches épaisses recoivent chacun plusieurs impressions successives. Dans un procédé type, on imprime d'abord la couche conductrice et on la cuit; ensuite on imprime et cuit les résistances qui seront ajustées aux valeurs requises. Ce procédé peut comprendre en outre l'impression d'une couche isolante. On peut ainsi déposer successivement des couches par exemple: conductrice, isolante, conductrice et résistante. En définitive, l'ensemble des phases du procédé peut être résumé dans le schéma suivant:

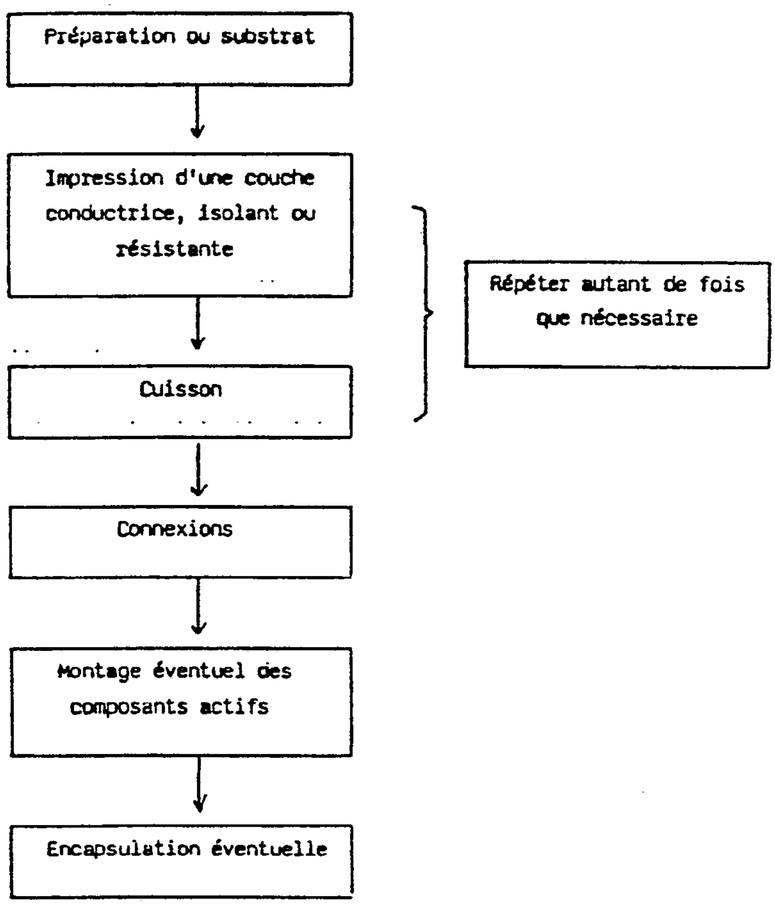


En ce qui concerne les encres de sérigraphie nécessaires à la fabrication des circuits à couches épaisses qui viennent d'être décrits, elles sont donc de trois sortes: des encres conductrices, résistantes et isolantes. Les encres conductrices et résistantes sont constituées en général par l'association d'une charge métallique avec un liant et éventuellement un diluant permettant d'ajuster les propriétés rhéologiques des encres. La cuisson, en modifiant la structure chimique du liant, fixe le dépôt métallique au substrat et permet d'obtenir le circuit conducteur ou résistant déinitif souhaité. Les encres isolantes différent essentiellement des précédentes par le fait qu'elles ne contiennent pas de charges métalliques conductrices.

De manière courante en matière de circuits hybrides, le liant de l'encre consiste en des particules inorganiques comme par exemple des verres spéciaux fusibles en poudre. Ces encres au verre étant cuites aux environs de 700°C à 1100°C, leur emploi conduit à retenir, comme substrats isolants, de préférence des céramiques et, comme charges métalliques conductrices, des poudres de métaux nobles non oxydabes, notamment le platine, l'or,l'argent ou les alliages palladium-or, palladium-argent, platine-or ou des poudres d'oxydes conducteurs dérivés de métaux nobles. Du fait de l'emploi des métaux nobles, l'adoption de cette technique entraine des dépenses onéreuses qui vont constituer un frein à son développement. On a proposé de faire appel à des poudres de metaux nobles, comme par exemple le cuivre, mais il convient alors dans ce cas de

procédér à la cuisson finale en atmosphère non oxydante et cette mesure vient compliquer la technologie des fours utilisables.

Il est possible de remplacer le liant inorganique dont on vient de parler par un liant organique comme par exemple une résine époxyde. Les températures de cuisson de l'encre requises dans ce cas sont nettement moins élevées que dans celui des liants inorganiques; elles se situent généralement entre 100° C et 300° C. Il est alors possible de faire appel à d'autres types de substrats isolants que les céramiques, comme par exemple des résines organiques renforcées et d'utilisier des encres à base d'une charge métallique non noble, les risques d'oxydation de la charge métallique au cours d'une cuisson conduite de manière classique à l'air ambiant entre 100° C et 300° C étant très atténués. Les encres ainsi préparées et cuites présentes cependant un inconvénient important: elles sont difficilement soudables. Outre leur rôle de conduire un courant électrique, les encres doivent en effet être des prises de contact pour recevoir des fils ou éventuellement des pattes de composants actifs, ce qui sous entend une exellente soudabilité, notament à l'aide d'alliages à base d'etain.

En matière de métallisation de substrats isolants, on a proposé, pour réaliser des circuits imprimés conducteurs de bonne qualité pouvant supporter sans paine une soudure, d'utiliser des encres comprenant un liant organique en matière polymérique et une charge métallique à base d'oxyde cuivreux (cf. brevets américains N° 3.226.256 et 3.347.724). Après cuisson, le dépôt obtenu est soumis à une réduction par traitement avec un acide pour transformer l'oxyde cuivreux en cuivre métallique; cette couche de cuivre est ensuite renforcée par dépôt d'un métal ductile qui peut être encore du cuivre en utilisant une réaction chimique d'oxydo-réduction. On sait que la réduction de l'oxyde cuivreux par un acide fait intervenir la formation d'un sel cuivreux instable qui se dismute pour donner d'une part des sels cuivriques et d'autre part du cuivre métallique qui se dépose selon la réaction:

$$Cu_2O + 2H^+ \longrightarrow Cu^{++} + Cu + H_2O$$

Dans une telle réduction, le rendement en cuivre métallique est bien inférieur à 50 %: en effet la moitié seulement du cuivre de départ est susoeptible de se transformer en métal oonducteur et de plus une partie de ce cuivre réduit est dissoute par l'agent acide utilisé. Le résultat en est que le dépôt métallique obtenu va être que très faiblement conducteur. C'est la raison pour laquelle, dans cette technique, on procédé toujours après l'étape de réduction à une recharge métallique du circuit déposé. Le fait que oette recharge est réalisée par voie chimique d'oxydo-réduction et non par voie électrolytique (qui ne marche pas) est une confirmation du caractère pau conducteur du dépôt original. Un premier inconvénient à cette méthode réside dans le fait que la recharge en métal est une opération longue, la vitesse de dépôt étant en effet de l'ordre de 1 µm par heure. Un second inconvénient réside dans le fait qu'il va y avoir une augmentation de l'épaisseur du dépôt original qui pourra atteindre 100 % et cette augmentation de l'épaisseur est de nature à limiter le nombre des oouches déposées par sérigraphie pour éviterune parte de planéité trop importante du substrat à la suite des dépôts successifs.

Ainsi la nécessité se faisait sentir de développar, en matière de fabrioation de circuits hybrides, une technique au moyen de laquelle on puisse déposer économiquement et de façon techniquement simple des circuits conducteurs sans recharge électro-chimique, soudables et ne comportant pas de sur-épaisseurs.

Par ailleurs, comme il l'a été expliqué ci-avant, les circuits hybrides à oouches epaisses recoivent chacun plusieurs impressions sérigraphiques successsives. Par exemple, un condensateur sera forme par le dépôt et la cuisson de l'électrcde inférieure (1), l'impression etla cuisson du diélectrique (2) et l'impression de l'électrode supérieure (3) suivie d'une cuisson de l'ensemble (cf. la figure 1 dans le dessin ci-joint qui représente un oondensateur en ooupe). Le procédé de fabrication implique donc trois dépôts successifs avec deux encres différentes: une encre conductrice et une encre isolante. Pour d'autres types de circuits hybrides, le procédé de fabrication pourra impliquer en plus des dépôts supplémentaires avec une encre résistante. La nécessité se faisait sentir là aussi de développar une technique parmettant de simplifier le protocole d'impression des couches, notamment en limitant le nombre des encres nécessaires.

Il a maintenant été trouvé, et c'est ce qui constitue l'un des objets de la présente invention, un procédé de fabrication de cicuits hybrides à couches épaisses qui permet de répondre à la satisfaction des objectifs définis ci-avant.

Plus précisément, la présente invention concerne un procédé de fabrioation de circuits hybrides à couches épaisses qui consiste à imprimer des circuits voulus sur un substrat isolant par dépôt en fonction du tracé choisi et cuisson d'une encre appropriée, ces opérations de dépôt et cuisson étant répetées au besoin autant defois que nécessaire, ledit procédé étant caractérisé en ce que l'on utilise une encre isolante, comprenant un oxyde non oonducteur dérivé d'un métal non noble, qui présente la particularité selon sa composition d'être potentiellement conductrice ou potentiellement résistante et que le caractère oonducteur ou résistant de l'encre est révélé après sondépôt et sa cuisson en la soumettant à l'action d'un borohydrure, d'une part pour pouvoir réduire rapidement et de manière quantitative l'oxyde métallique en métal conducteur et d'autre part pour pouvoir moduler aisément l'importance de la réduction dans l'épaisseur du dépôt effectué.

Plus précisement enoore, la présente invention se rapporte à un procédé de fabrication de circuits hybrides dans lequel la charge métallique de l'encre consiste préférentiellement en de l'oxyde cuivreux.

Un autre objet de la présente invention réside dans les encres potentiellement conductrices et résistantes destinées à la mise en oeuvre du présent procédé.

Un autre objet encore réside dans les circuits hybrides obtenus par application du présent procédé.

Quand on parle d'une encre potentiellement conductrice, on entend définir une encre qui va présenter, après cuisson et réduction, une résistivité suparficielle qui s'élève au plus à 0,1 Ω/□. Quand on parle d'une encre potentiellement résistante, on entend alors definir une encre qui va presenter, après cuisson et réduction, une résistivité superficielle qui va varier entre 10 et une valeur de $10^3$ Ω/□ ou plus. La résistivité que l'on souhaite obtenir va dépendre d'une part de la composition de l'encre et d'autre part de l'importance de la réduction dans l'épaisseur du dépot effectue.

De manière genérale, les encres destinées à la mise en oeuvre du procedé conforme à l'invention, sont constituées, avant cuisson, par l'association d'au moins une charge à base d'oxyde cuivreux avec un liant et un diluant parmettant d'ajuster la rhéohogie de l'encre. S'agissant de l'encre potentiellement oonductrioe, elle se distingue par le fait qu'elle renferme une charge unique à base d'oxyde cuivreux qui représente 40 à 70 % du poids de l'encre et un liant qui représente 4 à 10 % du poids de l'encre. S'agissant de l'encre potentiellement résistante, elle se distingue par le fait qu'elle renferme un mélange de charges comprenant 40 à 60 % en poids d'oxyde cuivreux et 60 à 40 % en poids d'une charge isolante totalement inerte dans les oonditions de la réduction, comme par exemple de la poudre de verre, des silicates aloalins, de l'alumine, des carbonates et sulfates naturels, ce mélange de charges représentant 30 à 60 % du poids de l'encre et un liant qui représente 10 à 30 % du poids de l'encre.

Bien que des liants inorganiques puissent être mis en oeuvre, on utilise avantageusement, pour les encres selon l'invention, des liants organiques. Comme types de liants organiques qui conviennent,on citera notamment: les résines du type phénolique telles que par exemple les condensats de phénol, résorcinol, crésol ou xylénol avec du formaldeyoe ou du furfural; les résines du type polyester insaturé préparées par exemple par réaction d'un anhydride d'acide dicarboxylique non sature avec un polyalkylèneglycol; les résines du type époxy telles que par exemple les produits de réaction de l'épichlorhydrine sur le bisphénol A; les résines du type polyimide telles que par exemple celles obtenues par réaction entre un N,N'-bis-imide d'acide dicarboxylique non saturé, une polyamine primaire et éventuellement un adjuvant approprié.

La résine utilisée est généralement à l'état de prépolymère thermodurcissable (présentant un point de ramollissement et encore soluble dans certains solvants) au moment de la préparation de l'encre et elle est à l'état complètement réticulé (infusible et totalement insoluble) dans l'encre telle qu'elle est obtenue après cuisson. La résine à l'état de prépolymère utilisée au départ peut renfermer avantageusement un catalyseur de durcissement.

De manière préférentielle, le liant consiste en une résine du type polyimide obtenue par réaction entre un N,N'-bis-imide d'acide dicarboxylique insaturé et une polyamine primaire selon les indications donnés dans le brevet français N° 1 555 564, dans les brevets américains N° 3 562 223 et 3 658 764 et dans la réissue américaine N° 29 316 ; la la substance de ces divers documents est incorporée ici en référence. La résine polyimide peut encore être obtenue par réaction entre le bis-imide, la polyamine et divers adjuvants tels que par exemple des mono-imides (selon le brevet ifrançais N° 2 046 498), des monomères,

autres que des imides, comportant un ou plusieurs groupements polymérisables du type $CH_2 = C<$ (selon le brevet français N° 2 094 607), des polyesters insaturés (selon le brevet français N° 2 102 878) ou des composés organosiliciques hydroxylés (selon le brevet français N° 2 422 696); la substance de ce divers documents est également incorporée ici en préférence. Dans le cas ou l'on utilise de pareils adjuvants, il faut rappeler que la résine polyimide à l'état de prépolymère peut être: soit le produit de réaction d'un bis-imide, d'une polyamine avec un adjuvant, soit le produit de réaction d'un prépolymère de bisimide et de polyamine avec un adjuvant, soit encore le mélange d'un prépolymère de bis-imide et de polyamine avec un adjuvant.

La résine polymide à l'état de prépolymère utilisée au départ peut renfermer avantageusement de petites quantités d'un initiateur de polymérisation radicalaire tel que par exemple le peroxyde de dicumyle, le peroxyde de lauroyle, l'azobisisobutyronitrile ou d'un catalyseur de polymérisation anionique tel que par exemple le diazabicyclooctane.

Plus préférentiellement encore, utilise dans la présente invention une résine polyimide issue de la réaction entre un bis-maléimide comme le N, N'-4, 4'-diphénylméthane-bis maléimide et une diamine primaire comme le diamino-4, 4' diphénylméthane et éventuellement l'un des divers adjuvants précités.

S'agissant des diluants utilisables, ils consistent en général en des liquides organiques de viscosités variées, pouvant aller par exemple de 1 cPo à plusieurs dizaines de poises, dont la nature chimique n'est pas critique dès l'instant où il ne s'agit pas de sorvants du lian mis en oeuvre à l'état de prépolymère thermodurcissable, ni de solvants de la laque qui obture certaines mailles d'un écran srigraphique. Comme types de diluants qui conviennent, on citera notamment: des éthers d'alcanols et de glycols tels que par exemple le diglyme, le butoxyéthanol; des alcools terpéniques tels que par exemple les α -,β ett γ terpinéols.

Un diulant qui convient particulièrement bien, notamment quano le liant choisi appartient au groupe préferé des résines du type polyimide défines ci-avant, consiste dans l'α -, β - ou γ -terpinéol.

S'agissant de la composition des encres, il reste à préciser encore que l'oxyde cuivreux, la charge totalement

inerte et le liant sont mis en oeuvre sous forme de poudres. La granulométrie des charges est généralement comprise entre, 0,1 et 5 μ m, tandis que la granulométrie du liant est énéralement comprise entre 5 et 40 μ.

Il a été indiqué ci-avant que la résistivité que l'on souhaite obtenir pour la dépôt va déprendre, outre de la composition de l'encre, de l'importance de la réduction dans l'épasseur du dépôt effectué. Cela conduit à examiner maintenant plus en détail la nature du traitement réducteur effectué après cuisson.

On a donc constaté que la transformation de l'oxyde cuivreux en cuivre métallique peut être conduite facilement et de manière quantitative par action des borohydrures. La transformation est représentée par la réaction: $_4Cu_2O + BH_4^- \rightarrow {}_8Cu + 8(OH)_3 + OH^-$

Cette facilité de réaction est probablement due à l'effet catalytique du cuivre métal qui pourrait s'expliquer par la formation intermédiaire d'hydrure de cuivre instable.

Les borohydrures utilisables dans la présente invention englobent des borohydrures substitués aussi bien que des borohydrures non substitués. Des borohydrures substitués dans lesquels au plus trois atomes d'hydrogène de l'ion borohydrure ont été remplacés par des substituants inertes comme par exemple des radicaux alkyles, des radicaux aryles, des radicaux alkoxy peuvent être utilisés. On fait appel de préférence à des bobohydrures alcalins dans lesquels la partie alcaline consiste en du sodium ou du potassium. Des exemples typiques de composés qui conviennent sont: le borohydrure de sodium, le borohydrure de potassium, le diéthylborohydrure de sodium, le triméthoxyborohydrure de sodium, le triphénylborohydrure de potassium.

Le traitementa réducteur est conduit de manière simple par mise en contact de l'encre après cuisson avec une solution de borohydrure dans l'eau ou dans un mélange d'eau et d'un solvant polaire inerte comme par exemple un alcool aliphatique inférieur. On donne la préférence aux solutions purement aqueuses de borohydrure. 8'agissant de la concentration de ces solutions, elle peut varier dans de larges limites et elle se situe de préférence entre 0,5 et 10% (en poids de borohydrure dans la solution). Le traitement réducteur peut être effectue à température élevée, cenpendant on préfère la mettre en oeuvre à une température voisine de la températutre ambiante, par exemple entre 15° C et 30° C. A propos du déroulement de la réaction, il faut noter qu'elle donne naissance à du $8(OH)_3$ et à des ions $OH^-$ qui ont pour effet d'induire une augmentation du pH du milieu au cours de la réduction. Or à des valeurs de pH élevées, par exemple suérieures à 13, la réduction est ralentie de sorte qu-il peut être avantageux d'opérer dans un milieu tamponné pour avoir une vitesse de réduction bier fixée.

C'est en jouant principalement sur la durée du traitement qu'il est possible de moduler efficacement l'importance de la réduction dans l'épaisseur du dépôt et par voie de conséquence de moduler la valeur des résistivités qui vont se développer. La durée du traitement est en général assez courte et elle se situe habituellement entre une minute ou moins et une dizaine de minutes. Pour une durée de traitement donnée, il est possible d'agir encore sur la vitesse de réduction en ajoutant dans le milieu des accélérateurs variés comme par exemple de l'acide bourique, de l'acide oxalique, de l'acide citrique, de l'acide tartrique ou des chlorures de métaux tels que le chlorure de cobalt-II, de nickel-II, de fer-II, de maganèse-II, de cuivre-II. En début de réduction, la réaction concerne essentiellement les grains d'oxyde cuivreux qui se trouvent en surface du dépôt et qui sont en contact direct avec l'agent réducteur. Du fait de l'effet catalytique du cuivre métal, la réaction de réduction va se poursuivre ensuite dans l'épaisseur du dépôt, et ceci bien que l'encre ne présente pas un caractère hydrophyle particulièrement marque. Suivant la durée du traitement, l'épaisseur d'encre qui est effectivement soumise à la réduction peut représenter de 10 à 100% de l'épaisseur du dépôt.

Il convient de noter que la valeur des résistivités est également fonction de la géomérie des parties conductrices ou résistantes sélectionnées. Cet aspect de la question conduit maintenant à parler de méthodes selon lesquelles les circuits voulus peuvent être construits sur le substrat isolant. Une première méthode consiste à déposer les encres en faisant appel à la technique utilisée de manière classique en matière de fabrication de circuits hybrides, c'est-à-dire à la technique de sérigraphie. Cependant conformément à la présente invention, la réalisation d'un circuit conducteur ou résistant va impliquer, après cuisson de l'encre et avant de procéder à l'impression suivante, d'effectuer un traitement réducteur du dépôt. Il doit être entendu que dans le cas de l'impression d'un circuit isolant, l'encre utilisée qui peut être soit potentiellement conductrice, soit potentiellement résistante ne subira par contre après cuisson aucun traitement réducteur.

La double aptitude de la charge à base d'oxyde cuivreux de conférer à la même un exellent caractère isolant à l'origine et un exellent caractère conducteur ou résistant après réduction permet de modifier profondément la méthode classique, dont on a parlé ci-avant, utilisée juscu'ici. Il est maintenant possible et c'est ce qui constitue l'objet d'une seconde méthode, particulièrement avantageuse, de remplacer le dépôt sélectif par sérigraphie par un dépôt uniforme d'une encre potentiellement conductrice ou résistante, par exemple par immersion, pulvérisation, calandrage, dépôt au racle, transfert, suivi, après cuisson de l'encre, lorsqu'il convient de réaliser des circuits conducteurs ou résistants, par un développement sélectif des parties conductrices ou résistances par réduction en utilisant la technique du masquage. Cette technique du masquage est utilisée habituellement dans le domaine des circuits imprimés et elle n'a pas encore reçu à notre connaissance d'application dans le domaine des circuits hybrides à couches épaisses. Rappelons que cette technique consiste à recouvrir la couche d'encre uniformément déposée et cuite par une résine photosensible, appelée encore photorésist, et à insoler ensuite cette résine photosensible au travers d'un masque à l'aide d'un rayonnement riche en rayons ultraviolets. Les résines photosensibles sont des compositions organiques qui subissent une transformation chimique sous l'action des rayons ultraviolets modifiant leur solubilité dans certains solvants. Le masque est destiné à laisser passer le rayonnement de manière sélective, selon le dessin du circuit à imprimer. Il est souvent exécuté dans une fine couche de chrome déposée sur une plaque de verre ou dans un film de gélatine

photographique. Si l'on utilise un photorésist positif, les parties non opaques du masque correspondent à l'emplacement du circuit voulu; dans le cas d'un photorésist négatif, ce sont au contraire les parties opaques qui correspondent à l'emplacement du circuit voulu. On procédé ensuite à un développement qui consiste à dissoudre les parties appropriées de la résine photosensible, c'est-à-dire selon la nature du photorésist: soit les parties rendues solubles par l'insolation dans le cas d'un photorésist positif, soit les parties non exposées et non durcies par l'insolation dans le cas d'un photorésist negatif. L'encre potentiellement conductrice ou résistante apparait donc aux emplacements correspondant aux parties dissoutes. Le reste des opérations comprend l'attaque réductrice de l'encre ainsidé couverte, puis l'élimination de la couche de résine photosensible qui reste et qui est devenue dès lors inutile; l'encre qui a été protégée par le photorésist, ne subissant aucune attaque réductrice, demeure quant à elle isolante.

L'application de cette seconde méthode est donc très intéressante puisqu'il est maintenant possible, en partant d'une seule encre potentiellement conductrice, de sélectionner sur une même couche de dépôt des zones conductrices et des zones isolantes. De la même façon, en partant d'une encre potentiellement résistante, il est possible egalement de sélectionner sur une même couche de dépôt des zones résistantes et des zones isolantes, les zones résistantes ne présentant d'ailleurs pas, pour une encre donnée, une valeur unique de résistivité mais des valeurs de résistivités variables qui peuvent être aisément ajustées grêce à l'action du traitement réducteur.

Pour reprendre l'exemple du condensateur, sa fabrication peut être réalisée maintenant de la manière simplifiée suivante: on dépose d'abord de manière non sélective une première couche (4) d'une encre potentiellement conductrice; puis, après coisson, on applique le traitement réducteur en précence du masque, ce qui va permettre de développer sélectivement l'électrode inférieure (4a) et une zone diélectrique (4b); on dépose ensuite de manière non selective une seconde couche (5) de la même encre dont la réduction sélective va permettre de faire apparaître l'électrode supérieure (5a) et une autre zone diélectrique (5b) (cf. la figure 2 dans le dessin ci-joint qui représente ce condensateur en coupe). Par rapport à l'état antérieur de la technique faisant appel à la sérigraphie, non seulement le nombre des dépôts nécessaires est réduit de trois à deux, mais encore le nombre des encres nécessaires est réduit de deux (encres conductrice et isolante) à un (encre potentiellement conductrice). De la même façon, la technique développée dans la présente invention permet de substituer à l'ensemble des trois encres utilisées jusqu'ici dans la domaine des circuits hybrides (encres conductrice, résistante et isolante), deux encres seulement, l'une potentiellement conductrice, l'autre potentiellement résistante.

Une troisième méthode de construction des circuits voulus qui peut être mise en oeuvre avantageusement consiste à utiliser à la fois la technique de sérigraphie et la technique de masquage. On peut utiliser dans ce cadre la technique de sérigraphie pour réaliser le ou les premier(s) niveau(x) de circuits et faire appel ensuite à la technique du masquage pour réaliser le ou les niveau(x) suivant(s) de circuits. On peut également réaliser l'enchainement comprenant un ou plusieurs dépôt(s) sérigraphique(s), puis un ou plusieurs dépôt(s) par la technique du masquage, puis un ou plusieurs dépôt(s) sérigraphique(s). La mesure consistant à procéder, après des dépôts sérigraphiques, à des dépôts uniformes par la technique du masquage permettra un niv•élément de l'ensemble du substrat autorisant ainsi d'entreprendre dans de bonnes conditions de planéité des dépôts ultérieurs. La technique classique par sérigraphie donne en effet naissance, après dépôt de l'encre, à des zones en relief qui correspondent aux chemins du circuit voulu et à des zones en creux qui correspondent àux parties du substrat non revêtu et il est facile de comprendre qu'à l'occasion des dépôts successifs opérés,ce défaut de planéité du substrat va s'accroitre de façon sensible. La technique du masquage, du fait d'un dépôt initial uniforme, va donner naissance par contre a des couches parfaitement planes même après réduction et elle permet donc, lorsqu'elle est appliquée apré des dépôts sérigraphiques, de corriger aisément les déraúts de planéité engendrés par la sérigraphie.

Les methodes de dépôt qui viennent d'être expliquées conduisent à des couches potentiellement conductrices ou résistantes dont l'épaisseur après cuisson est comprise en général entre 10 et 50µ met plus précisément entre 15 et 35µ m.

De manière générale, les encres, une fois déposées, sont séchées avant d'être soumises à une cuisson. Ce séchage, à des températuresde l'ordre de 50°C à 100°C, peut se faire notamment en étuve, sur plaque chauffante ou par rayonnement infrarouge. La durée du séchage est de l'ordre de une minute à une dizaine de minutes. Après séchage, les encres sont cuites à une température plus élevée pour compléter l'elimination ou diluant et pour lier le dépôt au substrat et leur acquérir leurs caractéristiques définitives. Les températures de cuisson se situent généralement entre 100°C et 300°C. Dans le cas où le liant de l'encre appartient au groupe préféré des résines du type polyimide, la température de cuisson est i de préférence comprise entre 140°C et 200°C. La cuisson s'effectue en général à l'air, dans un four statique ou un four tunnel.

Pour le reste, les substrats isolants qui utilisables ici peuvent être l'un quelconque des composés connus à cet effet dans l'art antérieur. On donne la préférence aux résines polymériques renforcées dans lesquelles la partie polymérique correspond aux résines définies ci-avant a propos du liant des encres conformes à la présente invention. Les résines renforcées du type phénolique, du type polyester insaturé, du type époxy et du type polyimide conviennent donc bien. Ces substrats sont en général des stratifiés complètement polymérisés dans lesquels rentrent l'un et/ou l'autre des principaux renforts suivants: les papiers de cellulose, les tissus de coton, les tissus et papiers d'amiante, les tissus de verre, les mats de verre. D'autres types de charge de renforcement peuvent bien entendu être utilisées. De pareils stratifiés sont bien connus de l'art antérieur et ne demandent pas à être décrits plus en détail.

On précisera que la technique qui vient d'être décrite permet d'obtenir des chemins conducteurs qui sont bien entendu parfaitement aptes à la soudure.

Il va de soi que des modifications peuvent être apportées aux modes de réalisation qui viennent d'être décrits, notamment par substitution de moyens équivalents, par exemple en matière d'oxyde métallique non noble utilisable, sans pour cela sortir du cadre de la présente invention. C'est ainsi que l'on peut remplacer l'oxyde cuivreux par d'autres oxydes métalliques non nobles dont le degré d'oxydation est choisi de manière à permettre une réduction facile de l'oxyde par le borohydrure; des oxydes qui peuvent convenir sont par exemple l'oxyde de nickel-II, l'oxyde de cobalt-II, l'oxyde de plomb-II, l'oxyde de cadmium-II, l'oxyde de chrome-III, l'oxyde d'antimoine-III, l'oxyde d'étain-IV.

Les exemples suivants donnés à titre non limitatif illustrent l'invention et montrent comment elle peut être mise en oeuvre.

**EXEMPLE 1**

On va décrire dans cet exemple une encre potentiellement conductrice conforme à la présente invention.

On mélange à sec:

. 40,5g d'oxyde cuivreux dont les grains présentent une granulométrie comprise entre 0,5 et 2μ m;

. 4,5g d'une poudre de granulométrie inférieure à 30μ m d'un prépolymère préparé à partir de N, N'-4, 4'-diphenylméthane-bis-maléimide et de diamino-4,4'-diphénylméthane (rapport molaire bis-imide/diamine = 2,5), présentant un point de ramollissement de 105°C.

On incorpore ensuite dans le mélange pulvérulent obtenu 30g d' terpinéol renfermant à l'état dissout 0,09g de peroxyde de dicumyle. L'ensemble est homogénéisé dans un mortier. Dans le cas où les divers composes precites sont utilises en quantités plus importantes, l'homogénéisation peut-être conduite par exemple dans un broyeur à cylindre ou dans l'autres types d'appareils comme ceux utilisés pour homogénéiser les peintures. La rhéologie de la pâte ainsi préparéeest parfaitement adaptée à une mise en oeuvre, notamment, par sérigraphie.

**EXEMPLE 2**

On va décrite dans cet exemple une encre potentiellement résistante conforme à la présente invention.

La préparation de cette encre est conduite de la manière indiquée ci-avant dans l'exemple 1, mais d'une part les 40,5g d'oxyde cuivreux sont remplacés maintenant par un mélange de 15g d'oxyde cuivreux avec 15g de poudre de verre présentant une granulométrie inférieure à 2μm et d'autre part les 4,5g de prépolymère polyimide sont remplacés maintenant par 15g du même prépolymère. La rhéologie de la pàte ainsi préparée est là aussi parfaitement adaptée à une mise en oeuvre notamment, par sérigraphie.

**EXEMPLE 3**

On va décrire dans cet exemple la réalisation d'un circuit conducteur par la technique du dépôt sélectif par sérigraphie.

Le substrat isolant utilisé est un stratifié à 12 plis comprenant 35 % en poids de résine époxy de type FR4 et 65% en poids de tissu de verre.

L'encre potentiellement conductrice conforme à l'exemple 1 est déposée sur ce substrat au travers d'un écran de sérigraphie en acier inoxydable de 325 mesh qui reproduit le dessin du circuit que l'on désire former. Le nappage ainsi que la définition du tracé obtenus sont de bonne qualite.

Le substrat x est ensuite séche une dizaine de minutes dans une étuve ventilée à 60°C, puis soumis à une cuisson pendant 1 heure à 175°C. Après séchage et cuisson, l'épaisseur du dépôt obtenu est de 18μm.

Ce dépôt, de couleur rouge, est immergé ensuite, après refroidissement, pendant une minute dans une solution aqueuse de borohydrure de soduim présentant une concentration de 1%. La solution de réduction est à la température ambiante, soit environ 20°C et elle est agitée. Au bout d'une minute de traitement, le dépôt rouge au départ devient rouge-brun et après rinçage et séchage, il fait apparaitre une résistivité de 0,05Ω/□.

**EXEMPLE 4**

On va décrire dans cet exemple la réalisation d'un circuit conducteur par la technique du dépôt uniforme, suivi d'une réduction sélective en utilisant un masque.

Dans cet exemple, le substrat isolant utilisé est un stratifié à 12 plis comprenant 35% en poids de résine polyimide préparée à partir de N,N'-4,4'-diphénylméthane-bis-maléimide et de diamino-4,4'-diphénylméthane

(rapport molaire bis-imide/diamine = 2,5) et 65% en poids de tissu de verre.

L'encre potentiellement conductrice conforme à l'exemple 1 est déposée de façon uniforme au racle sur toute la surface du substrat. Après séchage et cuisson 1 heure à 160°C, le dépôt obtenu présente une épaisseur de 27μm.

Un photorésist négatif, comprenant l'association d'une résine à base de polyisoprène cyclisé et de paraazidobenzacyclohexanone comme sensibilisateur, est alors déposé uniformément sur toute la surface de l'encre par pulvérisation. Après séchage, la couche de photorésist est exposée a travers un masque (fait en gélatine photographique et reproduisant le dessin négatif du circuit que l'on désire former) à la lumière d'un tube à vapeur de mercure pendant 20 secondes, puis on développe l'image en trempant le substrat pendant 1 minute dans du xylène pur de manière à enlever les parties du photorésist qui n'ont pas été insolées et qui de ce fait sont devenues solubles dans des milieux n'agissant pas sur les parties insolées. Les zones devant être conductrices apparaissent aux emplacements correspondant aux parties dissoutes.

En opérant comme indiqué à l'exemple 3, les zones potentiellement conductrices du substrat ainsi développées sont soumise ensuite à l'action de la solution réductrice de borohydrure de sodium. Enfin on procède à l'élimination totale du photorésist restant, les zones qui apparaissent alors étant isolantes; cette opération consiste dans la dissolution du photorésist par attaque (strippage) à l'aide d'un produit approprié mis dans le commerce par la Société RHONE-POULENC sous la dénomination RP 1 332, en opérant à 90°C - 100°C.

On obtient en définitive un circuit conducteur à couche épaisse parfaitement plan qui est apte à recevoir de nouveaux dépôts. Sa résistivité est de 0,065 Ω/□.

**EXEMPLE 5**

On va montrer dans cet exemple que les circuits conducteurs obtenus conformément à l'invention sont parfaitement aptes à la soudre.

Après réduction, rinçage et séchage, le circuit conducteur issu des exemples 3 ou 4 est immédiatement passé entre d'une part un rouleau presseur souple et d'autre part un rouleau entrainant un film d'eutectique à base d'étain. Un constate que les zones conductrices sont alors recouvertes d'une couche continue d'un alliage de cuivre et d'étain, ce qui indique la formation d'une soudure complète.

**EXEMPLE 6**

On va décrire dans cet exemple la mise en oeuvre d'une encre potentiellement résistante.

La mise en oeuvre de l'encre potentiellement résistante conforme à l'exemple 2, selon les modes opératoires décrits dans les exemples 3 (technique de la sérigraphie) et 4 (technique du masquage), conduit à l'obtention de couches résistantes qui présentent des résistivités respectivement de 227 Ω/□ et de 325 Ω/□.

**EXEMPLE 7**

On va décrire dans cet exemple la réalisation d'un circuit hybride à plusieurs couches épaisses en appliquant à la fois la technique de sérigraphie et la technique du masquage.

Les opérations successives qui sont effectuées sur le substrat apparaissent dans les figures 3 à 7 du dessin ci-joint qui représentent les coupes des substrats obtenus à l'issue de chaque opération. Le substrat isolant utilisé est le stratifié à 12 plis décrit dans l'exemple 3. Les opérations suivantes sont effectuées: (i) on dépose sélectivement sur le substrat par sérigraphie l'encre potentiellement conductrice conforme à l'exemple 1, puis on procède ensuite au séchage, à la cuisson et à la réduction du dépôt d'encre de la manière indiqué précedemment dans l'exemple 3. Les zones conductrices qui apparaissent ainsi constituent le premier niveau de conducteurs sont représentées par le repère (6) sur la figure 3;

(ii) On dépose en second lieu la même encre que précedemment de façon uniforme sur toute la surface du substrat issu de l'étape (i). Après séchage et cuisson, on obtient une couche isolante parfaitement plane qui est représentée par le repère (7) sur la figure 4; (iii) En appliquant la technique du masquage, on procède en troisieme lieu à une réduction sélective de la couche isolante (7) à l'endroit où l'on désire installer une jonction conductrice inter-couches. La zone conductrice qui est ainsi développée est représentée sur la figur 5 par le repère (8);

(IVi) En quatrième lieu, sur le substrat issu de l'étape (iii), on dépose à nouveau comme dans l'étape (ii), la même encre potentiellement conductrice de façon uniforme. La couche isolante obtenue après séchage et cuisson porte le repère (9) sur la figure 6;

(Vi) En cinquième lieu, en appliquant à nouveau la technique du masquage, on procède ensuite à la réduction sélective de la couche isolante (9) selon le tracé choisi pour ce second niveau de conducteurs. Les zones conductrices qui apparaissent alors sont représentées sur la figure 7 par le repère (10).

Les opérations (ii), (iii) et (IVi) sont répétées autant de fois qu'il y a besoin d'avoir un niveau de conducteurs

supplémentaire. Les opérations (IVi) et (Vi) sont répétées autant de fois qu'il y a besoin de réaliser un circuit conducteur supplémentaire. En utilisant des encres potentiellement résistantes, il est possible d'intercaller des circuits résistants de faibles dissipation thermique entre les couches, les circuits résistants de forte dissipation thermique devant être renvoyés en surface.

**Revendications**

1) Procédé de fabrication de circuits hybrides à couches épaisses qui consiste à imprimer des circuits voulus sur un substrat isolant par dépôt en fonction du tracé choisi et cuisson d'une encre appropriée, oes operations de dépôt et cuisson étant répétées aubesoin autant de fois que nécessaire, ledit procédé étant caractérisé ence que l'on utilise une encre isolante, comprenant un oxyde non conducteur dérivé d'un mêtal non noble, qui présente la particularité selon sa composition d'être potentiellement conductrice ou potentiellement résistante et que le caractère conducteur ou résistant de l'encre est révélé après son dépôt et sa cuisson en la soumettant à l'actiond'un borohydrure d'une part pour pouvoir réduire rapidement et de manière quantitative l'oxyde métallique en métal oonducteur et d'autre part pour pouvoir moduler aisément l'importance de la réduction dans l'épaisseur du dépôt effectue.

2) Procédé selon la revendication 1, caractérisé en ce que l'encre utilisée est oonsituée avant cuisson par l'association d'au moins une charge à base d'oxyde cuivreux avec un liant et un diluant.

3) Procédé selon la revendication 2, caractérisé en ce que l'encre potentiellement conductrice renferme une charge unique à base d'oxyde cuivreux qui représente 40 à 70 % du poids de l'encre et un liant qui représente 4 à 10 % du poids de l'encre.

4) Procédé selon la revendication 2, caractérisé en ce que l'encre potentiellement résistante renferme un mélange de charges oomprenant 40 à 60 % en poids d'oxyde cuivreux et 60 à 40 % en poids d'une charge isolante inerte, ce mélange de charges représentant 30 à 60 % du poids de l'encre et un liant qui représente 10 à 30 % du poids de l'encre.

5) Procédé selon l'une queloonque des revendicaton 2 à 4, caractérisé en ce que le liant utilisé pour la confection de l'encre est une matière polymérique à l'état de prépolymère thermodurcissable qui est prise dans le groupe formé par: les résines du type phénolique, les résines du type polyester insaturé, les résines du type époxy, les résines du type polyimide.

6) Procédé selon la revendication 5, caractérisé en ce que le liant utilisé est un prépolymère de type polyimide obtenu par réaction entre un N,N'-bis-imide d'acide dicarboxylique non saturé, une polyamine primaire et éventuellement un adjuvant tel que un mono-imide, un monomère polymérisable comportant un ou plusieurs groupements du type $CH_2 = C<$,

un polyester insaturé, un composé organosilicique hydroxylé. 7) Procédé selon l'une quelconque des revendications 2 à 6, caractérisé en ce que le diluant faisant partie de l'encre avant cuisson est pris dans le groupe formé par des éthers d'alcanols et de glycols et des alcools terpéniques.

8) procédé selon l'une quelconque des revendications 2 à 7, caractérisé en ce que les borohydrures utilisables englobent des borohydrures alcalins non substitués et des borohydrures substitués dans lesquels au plus trois atomes d'hydrogène de l'ion borohydrure ont été remplacés par des substituants inertes.

9) Procédé selon l'une quelconque des revendications 2 à 8, caractérisé en ce que l'agent réducteur est mis en contact avec l'encre, après cuisson, sous forme d'une solution dans l'eau ou dans un mélange d'eau et d'un solvant polaire inerte dont la concentration, exprimée en pourcentage en poids de borohydrure dans la solution, est comprise entre 0,5 et 10%.

10) procédé selon l'une quelconque des revendications 1 à 9, caractérisé en ce que la méthode d'impression des circuits voulus consiste à déposer sélectivement par sérigraphie l'encre potentiellement conductrice ou résistante, puis à cuire l'encre et enfin lorsqu'il y a lieu de réaliser des circuits conducteurs ou résistants, à soumettre le dépôt au traitement réducteur développer les parties conductrices ou résistantes voulues, les opérations de dépôt, cuisson et réduction etant répétées au besoin autant de fois que nécessaire.

11) procédé selon l'une quelconque des revendications 1 à 9, caractérisé en ce que la méthode d'impression des circuits voulus consiste a déposer de manière uniforme l'encre potentiellement conductrice ou résistante, puis à cuire l'encre et enfin, lorsqu'il y a lieu de réaliser des circuits conducteurs ou résistants, à développer sélectivement les parties conductrices ou résistantes voulues par réduction du dépôt en utilisant la technique du masquage, les opérations de dépôt, cuisson et reduction étant répétées au besoin autant de fois que nécessaire.

12) Procédé selon l'une quelconque des revendications 1 à 11, caractérisé en ce que la méthode d'impression des circuits voulus consiste à réaliser le ou les premier(s) niveau(x) de circuits en faisant appel à la technique de sérigraphie et à réaliser le ou les niveau(x) suivant(s) en faisant appel à la technique du masquage ou bien à réalise l'enchainement comprenant un ou plusieurs dépôt(s) sérigraphique(s), puis un ou plusieurs dépôt(s) par la technique du masquage, puis un ou plusieurs dépôt(s) sérigraphique(s).

13) Procédé selon l'une quelconque des revendications 1 à 12, caractérisé en ce que le substrat isolant est un strafifie complètement polymérisé constitué par l'association d'une résine du type phénolique, du type polyester insaturé, du type époxy ou du type polyimide avec une charge de renforcement à base de papiers de cellulose,

de tissus de coton, de tissus d'amiante, de tissus de verre ou de mats de verre..

14) A titre de moyens pour la mise en oeuvre du procédé selon l'une quelconque des revendications 1 à 13 précédentes, les encres potentiellement conductrices telles qu'elles sont définies dans les revendications 3 et 5 à 7 précédentes.

15) A titre de moyens pour la mise en oeuvre du procédé selon l'une quelconque des revendications 1 à 13 précédentes, les encres potentiellement résistantes telles qu'elles sont définies dans les revendications 4 et 5 à 7 précédentes.

**Patentansprüche**

1. Verfahren zur Herstellung von Hybridschaltungen in Dickschichttechnik, indem entsprechend den Strompfaden auf einem isolierenden Substrat eine Masse aufgetragen und eingebrannt wird und das Auftragen und Einbrennen der Masse bis zur Erreichung der gewÿnschten Schichtstärke wiederholt wird, dadurch gekennzeichnet, daß man eine isolierende·Masse enthaltend ein nichtleitendes Oxid eines nicht-edlen Metalls verwendet,die aufgrund ihrer Zusammensetzung leitend oder nicht-leitend sein kann, und man die Masse nach Abscheidung und Einbrennen leitend bzw. nicht-leitend macht, indem man sie der Einwirkung eines Borans (Boranats) aussetzt, einerseits um schnell und vollständig des Metalloxid zu leitendem Metall in der Dicke der abgeschiedenen Schicht zu beeinflussen.

2. Verfahren nach Anspruch 1, dadurch gekennzeichnet, daß die Masse vor dem Brennen zumindest ein Kupfer (I)-oxid, ein Bindemittel und ein Verdünnungsmittel enthält.

3. Verfahren nach Anspruch 2, dadurch gekennzeichnet, daß eine leitend werdende Masse 40 bis 70 Gew.-% Kupfer(I)-oxid und 40 bis 10 Gew.-% Bindemittel enthält.

4. Verfahren nach Anspruch 2, dadurch gekennzeichnet daß eine nicht—leitend werdende Masse ein Gemisch von 40 bis 60 Gew.-% Kupfer(I)-oxid und 60 bis 40 Gew.-% inertes Isoliermittel in einer Menge von 30 bis 60 Gew.-% zusammen mit 10 bis 30 Gew.-% Bindemittel enthält.

5. Verfahren nach einem der Ansprüche 2 bis 4, dadurch gekennzeichnet, daß das für die Bildung der Masse verwendete Bindemittel ein wärmehärtendesPrepolymer ist in Form von Phenolharzen, ungesättigten Polyesterharzen, Epoxyharzen und/oder Polyimidharzen.

6. Verfahren nach Anspruch 5, dadurch gekennzeichnet, daß man als Bindemitel ein Polyimid-Prepolymer verwendet, das durch Umsetzung einer ungesättigten N,N'-bis-Imidodicarbonsäure, einem primären Polyamin und gegebenenfalls einem Zusatz wie ein Monoimid, ein polymerisierbares Monomer mit einer oder mehreren CH = C-Gruppen, einem ungesättigten Polyester oder eine hydroxyorganische Siliciumverbindung erhalten worden ist.

7. Verfahren nach einem der Ansprüche 2 bis 6, dadurch gekennzeichnet, daß man als Verdünnungungsmittel für die Masse vor dem Einbrennen Alkanol, Ether, Glykole und/oder Terpenalkohole verwendet.

8. Verfahren nach einem der Ansprüche 2 bis 7, dadurch gekennzeichnet, daß man als Borane bzw. Boranate gegebenenfalls substiuierte Alkaliboranate verwendet, in denen höchstens 3 Wasserstoffatome durch inerte Substituenten ersetzt sind.

9. Verfahren nach einem der Ansprüche 2 bis 8, dadurch gekennzeichnet, daß man das Reduktionsmittel mit der Masse vor dem Einbrennen in Form einer wässrigen Lösung oder Mischung oder einer Lösung in einem inerten polaren Lösungsmittel in Berührung bringt, dessen Konzentration 0,5 bis 10 Gew.-% Boran bzw. Boranat beträgt.

10. Verfahren nach einem der Ansprüche 1 bis 9, dadurch gekennzeichnet, daß man das Aufdrucken der Masse durch Siebdruck vornimmt, dann die Masse einbrennt und man die Schicht, um sie nun leitend oder nicht-leitend zu machen, mit Reduktionsmittel behandelt und die Verfahrensstufen der Abscheidung der Masse, des Einbrennens und Reduzierens so oft wie erforderlich wiederholt.

11. Verfahren nach einem der Ansprüche 1 bis 9, dadurch gekennzeichnet, daß man die Masse zuerst gleichmäßig auf das Substrat aufträgt, dann einbrennt und zur Entwicklung selektiv leitender und nicht,leitender Bereiche unter Verwendung von Masken die Reduktion der Schicht vornimmt und man je nach Bedarf die Abscheidung, Einbrennung und Reduktion wieder

12. Verfahren nach einem der Ansprüche 1 bis 11, dadurchgekennzeichnet, daß man das erste bzw. die ersten Niveaus der Schaltung durch Siebdrucktechnik erzeugt und die folgende(n) durch Maskentechnik oder aber eine oder mehrere Schichten durch Siebdruck, anschließend eine oder mehrere Schichten durch Maskentechnik und einschließlich eine oder mehrere Schichten durch Siebdruck aufbringt.

13. Verfahren nach einem der Ansprüche 1 bis 12, dadurch gekennzeichnet, daß man ein isolierendes Substrat verwendet, welches ein vollständig durchpolymerisierter Schichtwerkstoff aus einem Phenolharz, einem ungesättigten Polyesterharz, einem Epoxyharz oder einem Polyimidharz mit Verstärkungseinlagen in Form von Zellstoffpapier, Baumwollgewebe, Asbestgewebe oder-papier oder Glasgewebe oder-matten ist.

14. Mittel zur Durchführung des Verfahrens nach Anspruch 1 bis 13, wobei die leitend werdenden Massen solche der Ansprüche 3 und 5 bis 7 sind.

15. Mittel zur Durchführung des Verfahrens nach Anspruch 1 bis 13, wobei die nicht-leitend werdenden Massen solche entsprechend den Ansprüchen 4 und 5 bis 7 sind.

## Claims

1. Process for the manufacture of thick-layer hybrid circuits which consists of printing the desired circuits on an insulating substrate by depositing a suitable ink in accordance with the desired path and baking the ink, these deposition and baking operations being repeated, where required, as many times as necessary, the said process being characterised in that there is used an insulating ink comprising a non-conductive oxide derived from a base metal, which oxide exhibits the peculiarity of being potentially conductive or potentially resistant depending on its composition, and that the conductive or resistant character of the ink is developed, after the ink has been deposited and baked, by subjecting it to the action of a borohydride, on the one hand to be able rapidly and quantitatively to reduce the metal oxide to conductive metal and on the other hand to be able easily to vary the extent of the reduction within the thickness of the deposit which has been produced.

2. Process according to Claim 1, characterised in that the ink used consists, prior to baking, of the combination of at least one filler based on cuprous oxide with a binder and a diluent.

3. Process according to Claim 2, characterised in that the potentially conductive ink contains a single filler based o-n cuprous oxide, representing 40 to 70% by weight of the ink, and a binder representing 4 to 10% by weight of the ink.

4. Process according to Claim 2, characterised in that the potentially resistant ink contains a mixture of fillers comprising 40 to 60% by weight of cuprous oxide and 60 to 40% by weight of an inert insulating filler, this mixture of fillers representing 30 to 60% by weight of the ink, and a binder which represents 10 to 30% by weight of the ink.

5. Process according to any one of Claims 2 to 4, characterised in that the binder used for making up the ink is a polymeric material in the form of a thermosetting prepolymer which is selected from the group consisting of resins of the phenolic type, resins of the unsaturated polyester type, resins of the epoxy type and resins of the polyimide type.

6. Process according to Claim 5, characterised in that the binder used is a prepolymer of the polyimide type obtained by reaction of an unsaturated dicarboxylic acid N,N'-bis-imide, a primary polyamine and, optionally, an adjuvant such as a monoimide, a polymerisable monomer comprising one or more groups of the $CH_2=C<$ type, an unsaturated polyester or a hydroxylic organosilicon compound.

7. Process according to any one of Claims 2 to 6, characterised in that the diluent forming part of the ink before baking is selected from the group consisting of ethers of alkanols and glycols, and terpene alcohols.

8. Process according to any one of Claims 2 to 7, characterised in that the borohydrides which may be used include unsubstituted alkali metal borohydrides and substituted borohydrides in which at most three hydrogen atoms of the borohydride ion have been replaced by inert substituents.

9. Process according to any one of Claims 2 to 8, characterised in that the reducing agent is brought into contact with the ink, after baking, in the form of a solution in water or in a mixture of water and an inert polar solvent, the concentration of the solution, expressed in percent by weight of borohydride in the solution, being between 0.5 and 10%.

10. Process according to any one of Claims 1 to 9, characterised in that the method of printing of the desired circuits consists in selectively depositing a potentially conductive or resistant ink by screen printing, then baking the ink and finally, if conductive or resistant circuits are to be produced, subjecting the deposit to the reducing treatment to develop the desired conductive or resistant parts, the operations of deposition, baking and reduction being repeated, where required, as often as necessary.

11. Process according to any one of Claims 1 to 9, characterised in that the method of printing of the desired circuits consists of uniformly depositing the potentially conductive or resistant ink, then baking the ink and finally, if conductive or resistant circuits are to be produced, selectively developing the desired conductive or resistant parts by reduction of the deposit, using the masking technique, the operations of deposition, baking and reduction being repeated, where required, as often as necessary.

12. Process according to any one of Claims 1 to 11, characterised in that the method of printing of the desired circuits consists of producing the first layer or layers of circuits by employing the screen printing technique and producing the subsequent layer or layers by employing the masking technique or carrying out a sequence oomprising one or more depositions by screen printing followed by one or more depositions by the masking technique followed by one or more depositions by screen printing.

13. Process according to any one of Claims 1 to 12, characterised in that the insulating substrate is a completely polymerised laminate consisting of the combination of a resin of the phenolic type, the unsaturated polyester type, the epoxy type or the polyimide type with a reinforcing filler based on cellulosic papers, cotton fabrics, asbestos fabrics, as bestos papers, glass fabrics or glass mats.

14. By way of means for carrying out the process of any one of Claims 1 to 13 above, the potentially conductive inks as defined in Claims 3 and 5 to 7 above.

15. By way of means for carrying out the process of any one of Claims 1 to 13 above, the potentially resistant inks as defined in Claims 4 and 5 to 7 above.

PLANCHE I-2

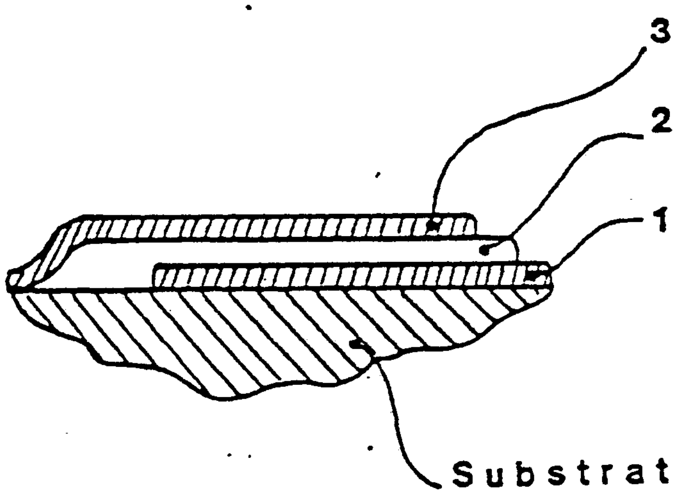


FIG.1

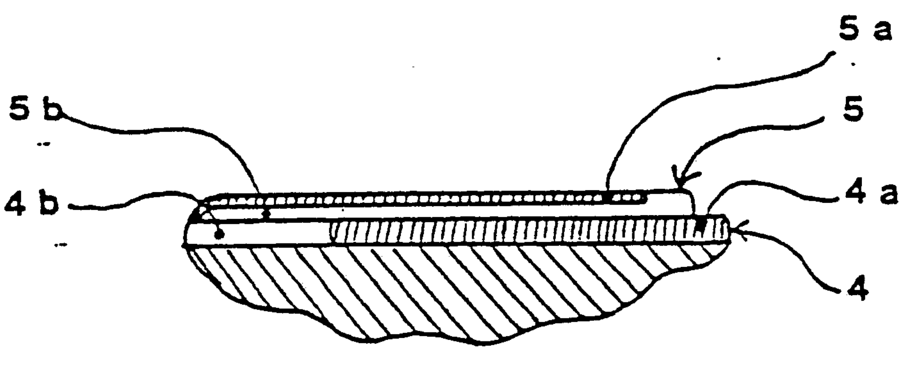


FIG.2

PLANCHE II-2

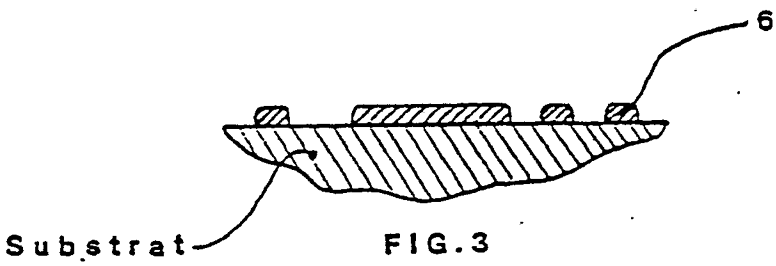


FIG.3

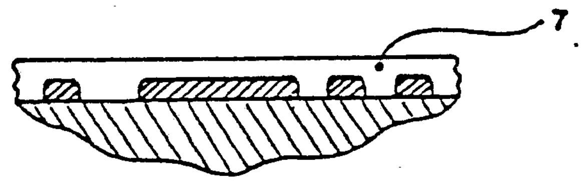


FIG.4

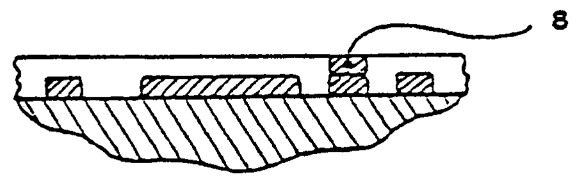


FIG.5

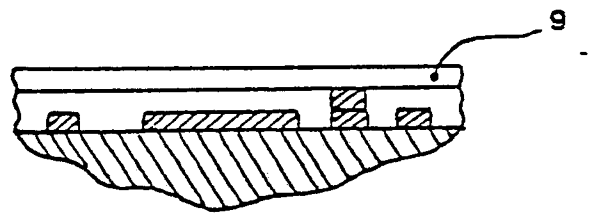


FIG.6

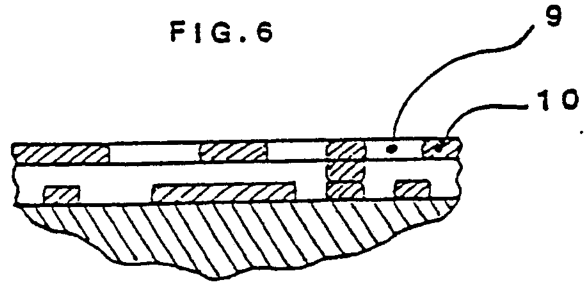


FIG.7